(19) Europäisches Patentamt / European Patent Office / Office européen des brevets

(11) **EP 3 491 371 B1**

(12) **FASCICULE DE BREVET EUROPEEN**

(45) Date de publication et mention de la délivrance du brevet:
**18.03.2020 Bulletin 2020/12**

(21) Numéro de dépôt: **17742500.6**

(22) Date de dépôt: **06.07.2017**

(51) Int Cl.:
**G01N 29/02** *(2006.01)*

(86) Numéro de dépôt international:
**PCT/FR2017/051850**

(87) Numéro de publication internationale:
**WO 2018/020096 (01.02.2018 Gazette 2018/05)**

(54) **RÉSONATEUR MÉCANIQUE OPTIMISÉ POUR FONCTIONNER DANS UN FLUIDE**

OPTIMIERTER MECHANISCHER RESONATOR ZUM BETRIEB IN EINER FLÜSSIGKEIT

MECHANICAL RESONATOR OPTIMISED TO OPERATE IN A FLUID

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.07.2016 FR 1601154**

(43) Date de publication de la demande:
**05.06.2019 Bulletin 2019/23**

(73) Titulaire: **Office National d'Etudes et de Recherches Aérospatiales 91120 Palaiseau (FR)**

(72) Inventeurs:
• **AOUST, Guillaume**
  **43300 SAINT ARCONS D'ALLIER (FR)**
• **BOURGETEAU, Béatrice**
  **92130 ISSY LES MOULINEAUX (FR)**
• **LEVY, Raphaël**
  **75014 PARIS (FR)**
• **LE TRAON, Olivier**
  **91430 VAUHALLAN (FR)**
• **JANIAUD, Denis**
  **91940 LES ULIS (FR)**

(74) Mandataire: **Plasseraud IP 66, rue de la Chaussée d'Antin 75440 Paris Cedex 09 (FR)**

(56) Documents cités:
**EP-A2- 0 101 669      WO-A2-2006/107900
FR-A1- 2 325 243      US-A- 4 429 248**

• **AOUST GUILLAUME ET AL: "Shape optimization for high quality factor flexural mechanical resonators operated in air", 2016 SYMPOSIUM ON DESIGN, TEST, INTEGRATION AND PACKAGING OF MEMS/MOEMS (DTIP), IEEE, 30 mai 2016 (2016-05-30), pages 1-4, XP032925540, DOI: 10.1109/DTIP.2016.7514840 [extrait le 2016-07-15]**

**Description**

Le domaine technique de l'invention est celui des résonateurs mécaniques destinés à être intégrés dans des instruments de métrologie, en particulier les instruments détectant la présence d'éléments chimiques dans l'atmosphère et en mesurant la concentration.

Le résonateur constitue l'élément sensible de l'instrument. La fréquence, la stabilité et la qualité de la résonance sont liées aux dimensions, à la géométrie, au matériau constitutif et à l'environnement du résonateur. La résonance est entretenue par des moyens externes.

Le facteur de qualité d'un résonateur est défini comme étant le rapport entre l'énergie stockée dans le résonateur, sous forme d'énergie cinétique et potentielle de déformation, et l'énergie perdue au cours d'un cycle d'oscillation.

Un des résonateurs mécaniques les plus connus est le diapason en quartz mis en œuvre dans l'industrie horlogère. La résonance est maintenue par un circuit électronique accordé, mais c'est la qualité de la résonance mécanique des deux poutres du diapason qui assure la stabilité et la pureté de la fréquence de résonance.

Ce résonateur étant encapsulé dans un boîtier où le vide a été réalisé, l'énergie se perd essentiellement dans le support de fixation.

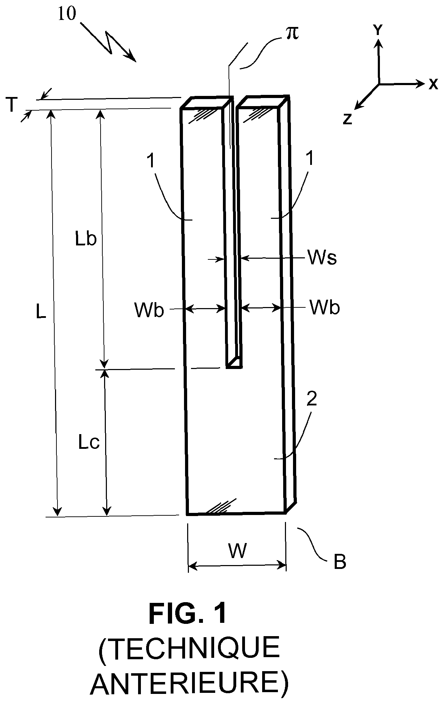

La figure 1 illustre un exemple de résonateur horloger 10 réalisé dans une plaque de quartz d'épaisseur T = 0,2 mm. Le diapason est formé de deux poutres parallèles parallélépipédiques 1 identiques solidaires à une de leurs extrémités d'une partie commune 2 fixée au support. Le diapason est ainsi symétrique par rapport au plan médian $\pi$ Les dimensions des poutres dans le plan de la plaque sont : longueur Lb = 3,8 mm et largeur Wb = 0,6 mm.

Pour faciliter l'usinage, la largeur Ws de la fente séparant les poutres est égale à 0,2 mm, c'est-à-dire égale à l'épaisseur T de la plaque.

L'élancement d'une poutre est défini comme étant le rapport entre sa longueur Lb et sa largeur Wb. Ainsi, dans l'exemple présenté, l'élancement vaut environ 6,3.

A la fréquence de résonance mécanique du diapason horloger, qui est de 32,768 kHz, les deux poutres vibrent en opposition de phase en flexion dans le plan de la plaque. L'élancement est suffisamment grand pour que les contraintes mécaniques soient essentiellement des contraintes alternatives d'extension et de compression réparties sur la longueur des poutres, mais qu'elles soient peu présentes dans la partie commune où elles s'atténuent rapidement, ce qui permet de limiter les pertes d'énergie lorsque la zone de fixation à l'embase est éloignée de la zone d'encastrement des poutres. Le facteur de qualité d'un tel résonateur est ainsi typiquement de l'ordre de 80 000.

Un circuit électronique externe accordé maintient la résonance au moyen d'électrodes disposées de façon appropriée et connue sur les poutres.

La maîtrise de réalisation et le bas coût de production de ces résonateurs incite à vouloir les utiliser dans des domaines techniques autres que celui de l'horlogerie, par exemple celui de la métrologie.

Des résonateurs de ce type sont utilisés dans des applications de mesure de grandeurs physiques, les déformations des poutres, induites par exemple par une accélération ou une rotation, sont détectées par des électrodes qui, outre leur fonction d'excitation d'un mode de résonance dit mode pilote, peuvent avoir une fonction de détection d'un mode de résonance, dit mode détecteur, modifié par la variation de la grandeur physique considérée (FR2954489).

Ces résonateurs sont aussi utilisés en présence d'un fluide, généralement un gaz ou un mélange de gaz comme l'atmosphère terrestre par exemple.

La présence d'un fluide modifie les pertes d'énergie subies par le résonateur. En plus des pertes dans le support de fixation, apparaissent des pertes liées au frottement visqueux des poutres avec le fluide et un couplage acoustique lié aux variations de pression du fluide engendrées par le mouvement des poutres.

Dans l'état de l'art de ce domaine, on peut citer l'utilisation de diapasons horlogers pour la technique de mesure dite Quartz Enhanced Photoacoutic Spectroscopy (QEPAS) introduite dans l'article intitulé "Quartz-enhanced photoacoustic spectroscopy", A. A. Kosterev & al, OPTICS LETTERS / Vol. 27, N° 21 / November 1, 2002 ».

L'onde acoustique est le moyen externe qui entretient la résonance du diapason. L'onde se propage à une vitesse constante c dans un fluide donné si la température et la pression P sont constantes. Dans l'atmosphère terrestre, dans les conditions normales de pression et de température, la vitesse du son est d'environ 340 m.s$^{-1}$.

Enfin, la longueur d'onde $\lambda$ du son est liée à sa fréquence f et à la vitesse de propagation c par la relation suivante :

$$\lambda = c/f \quad (R)$$

Les auteurs de l'article soulignent que le diapason horloger est très facile à mettre en œuvre (approvisionnement, coût), mais que sa conception n'est probablement pas optimisée vis-à-vis de la détection d'une onde photo acoustique. Ils suggèrent qu'un résonateur spécialement conçu pour cet usage devrait permettre d'améliorer la sensibilité du dispositif, mais sans donner plus d'indication (paragraphe central de la dernière colonne de l'article).

Comme l'essentiel des pertes d'énergie d'un tel résonateur est égal à la somme des pertes dans le support, des pertes dues aux frottements visqueux et des pertes dues au couplage acoustique, il est logique de minimiser chacune de ces pertes.

L'invention a pour but de présenter un résonateur dans lequel les pertes dues aux frottements visqueux et les pertes dans le support sont minimisées et dans lequel les pertes acoustiques sont au contraire favorisées et d'adjoindre à ce résonateur un moyen apte à lui restituer ses pertes acoustiques, l'ensemble constituant un dispositif optimisé ayant de faibles pertes, y compris acoustiques, donc ayant un facteur de qualité élevé.

L'invention est divulguée dans la revendication 1. Les revendication dépendantes divulguent des modes de réalisation préférées. L'invention porte sur un résonateur comportant une poutre, de longueur Lb et de largeur Wb, réalisée dans une plaque plane d'épaisseur T solidaire à l'une et/ou l'autre de ses extrémités d'une partie massive fixée à un support.

Cette poutre a un mode résonnant en flexion dans le plan de la plaque à une fréquence f. Ce mode résonnant est excité en présence d'une onde acoustique provenant d'une source d'énergie extérieure, par exemple d'un faisceau laser modulé à la fréquence f partiellement absorbé en traversant le fluide comme dans l'article précité. A proximité du faisceau, un transfert d'énergie du laser vers le fluide s'effectue à la fréquence f de modulation du laser, créant ainsi une onde acoustique de longueur d'onde $\lambda$.

Il est connu que, dans la relation (R), la vitesse c varie peu en fonction de la fréquence f de l'onde acoustique et de la pression P du fluide (pour des pressions supérieures à 10 Pa). De même, la vitesse c varie relativement peu en fonction de la température pour les températures habituellement rencontrées, c'est-à-dire entre -10°C et +40°C : c évolue comme la racine carrée de la température absolue dans l'hypothèse d'un gaz parfait.

Il est donc possible de concevoir un résonateur type ayant une grande sensibilité dans de nombreuses conditions d'utilisation tout en ayant des dimensions, une géométrie et un matériau constitutif définis.

Ainsi les résonateurs conformes à la présente invention sont des résonateurs mécaniques spécialement conçus pour favoriser le couplage avec une onde acoustique incidente et pour être intégrés dans des instruments de métrologie, en particulier les instruments mesurant la présence d'éléments chimiques absorbants dans un fluide qui peut être l'atmosphère terrestre.

Quand le mode résonnant est excité, la présence du résonateur perturbe relativement peu l'onde acoustique qui se propage dans tout l'espace environnant le résonateur. De ce fait, l'onde acoustique interagit non seulement sur la face de la poutre tournée vers la source d'énergie ou chant intérieur de la poutre, mais également sur la face opposée ou chant extérieur de la poutre.

Dans le cadre de la présente description, on entend par chant une face d'épaisseur du résonateur, qui est perpendiculaire au plan de la plaque, c'est-à-dire qui s'étend dans le sens de l'épaisseur de la plaque pour l'une de ses dimensions de face.

Si la source d'énergie est dans le plan de la plaque, mais éloignée de la poutre sur un axe coupant perpendiculairement sa longueur Lb, l'onde acoustique est considérée comme plane lorsqu'elle agit sur les chants de la poutre. Si la distance Wb entre les deux chants de la poutre est égale à $\lambda/2$, la variation de pression sur le chant intérieur de la poutre sera en opposition de phase avec la variation de pression sur le chant extérieur de la poutre, induisant une synergie des efforts exercés par l'onde acoustique sur la poutre. La nature périodique de l'onde acoustique conduit à des valeurs optimisées théoriques de $\lambda/2 + n.\lambda$, n étant un nombre entier positif ou nul.

Cette condition sur la largeur Wb de la poutre est nécessaire pour obtenir un résonateur selon l'invention.

Si la source d'énergie n'est pas en champ lointain, l'écart de phase entre les variations de pression sur les chants de la poutre est variable autour de $\Pi$. Cela conduit à définir une fourchette de valeurs de la largeur Wb comprise entre $\lambda/4 + n\lambda$ et $3\lambda/4 + n\lambda$, n étant un entier positif ou nul, dans laquelle la synergie des efforts exercés par l'onde acoustique sur les chants de la poutre est moindre mais existe encore.

Un résonateur selon l'invention peut présenter des perfectionnements pour améliorer ses autres performances.

Ainsi, selon un mode de réalisation, la longueur de la poutre est telle que seul le mode fondamental de résonance en flexion soit possible ce qui revient à limiter son élancement.

Pour une poutre encastrée à ses deux extrémités, l'élancement est compris entre 2 et 5, pour une poutre encastrée à l'une de ses extrémités l'élancement est compris entre 1,2 et 3,6.

La condition d'élancement ne dépend pas des dimensions absolues des poutres, c'est-à-dire que cette condition est valable quel que soit Lb. En revanche, la condition d'élancement dépend du matériau constitutif de la poutre et du fluide l'environnant.

Une telle conformation de la poutre limite les pertes d'énergie dues aux frottements visqueux des poutres avec le fluide.

De préférence, un résonateur selon l'invention sera un diapason comportant deux poutres adjacentes parallèles encastrées à une de leurs extrémités dans une partie commune. Le diapason, de façon connue, permet un meilleur confinement de l'énergie en limitant les pertes d'énergie dans le support.

Si dans un diapason horloger comportant deux poutres ayant un élancement d'environ 6,3 les contraintes sont essentiellement des contraintes alternatives d'extension et de compression réparties sur la longueur des poutres et peu présentes au niveau de l'encastrement dans la partie commune où elles s'atténuent rapidement, il n'en est pas de même lorsque le diapason comporte des poutres fonctionnant dans un fluide comme de l'air et ayant un élancement de l'ordre de 2,3.

A la fréquence de résonance mécanique du diapason, les deux poutres vibrent en opposition de phase en flexion dans le plan de la plaque, mais du fait de leur faible élancement, les contraintes mécaniques sont des contraintes alternatives d'extension/compression et de cisaillement au niveau de l'encastrement dans la partie commune.

Les modifications des contraintes liées à l'élancement réduit des poutres des résonateurs selon l'invention conduisent à définir une conformation particulière de la partie commune permettant de limiter les pertes dans le support.

Cette partie commune, massive, a la forme d'un parallélépipède rectangle dont la longueur est supérieure au double de la largeur d'une poutre et la hauteur supérieure à la longueur d'une poutre. Par massive, il faut comprendre pesante et non creuse. De part et d'autre de ce parallélépipède sont disposés deux trapèzes isocèles dont les grandes bases ont une longueur égale à la longueur de la partie commune. La petite base d'un des deux trapèzes isocèles supporte les poutres, les chants externes des poutres du diapason coïncidant avec les extrémités de cette base. La petite base de l'autre trapèze isocèle supporte l'élément de liaison intermédiaire reliant le résonateur à son support. La longueur de cette seconde petite base est très inférieure à la longueur du parallélépipède et de l'ordre de la moitié ou du tiers de la largeur d'une poutre, la surface de la partie commune étant voisine de trois fois la surface des deux poutres. En conséquence, la masse de la partie commune est voisine de trois fois la masse des deux poutres, c'est-à-dire comprise entre 2 fois et 4 fois, ou entre 2,5 et 3,5 fois, la masse des deux poutres.

Les pertes d'énergie vers le support sont ainsi réduites par rapport à celles d'un résonateur horloger.

Dans le fonctionnement envisagé dans l'invention, le résonateur optimisé est excité par une source d'énergie extérieure. Les électrodes n'ont donc qu'une fonction de détection.

Comme déjà décrit, l'élancement réduit des poutres des résonateurs selon l'invention induit, outre les contraintes de flexion dans les poutres, des contraintes de cisaillement dans la zone d'encastrement sur la partie commune.

La conformation particulière des électrodes est adaptée pour améliorer la détection, par effet piézoélectrique, des vibrations du résonateur.

Les électrodes ont deux polarités et couvrent, sous forme de plages conductrices, la totalité de la surface totale des deux poutres et de la partie commune hormis les zones d'isolation inter électrodes. De préférence, les zones d'isolation inter électrodes occupent moins de 20% de la surface totale des faces de chaque poutre et de la partie commune qui sont parallèles au plan de la plaque.

La conformation des électrodes est caractéristique du fait qu'elle concerne les poutres et la partie commune. De préférence, les électrodes d'une même face parallèle au plan de la plaque comprennent :

- une électrode centrale en forme de Y dont deux bras symétriques longent des faces d'épaisseur internes des deux poutres qui sont en vis-à-vis, et dont une queue relie un point central de l'élément intermédiaire de liaison,
- deux électrodes externes symétriques qui recouvrent chacune au moins 25% de la partie de face parallèle au plan de la plaque appartenant à la partie commune, chacune dans une zone latérale opposée de cette partie commune, et qui relient chacune un point externe respectif de l'élément intermédiaire de liaison, et
- deux électrodes intermédiaires symétriques, chacune ayant un bras qui longe une face d'épaisseur externe de l'une des poutres, une partie de retour qui entoure une extrémité de l'une des électrodes externes opposée à l'élément intermédiaire de liaison, et une queue reliant un point intermédiaire respectif de l'élément intermédiaire de liaison, entre le point central et l'un des points externes.

Il est possible de détecter la vibration du diapason en connectant un amplificateur de charges différentiel aux électrodes qui permet de générer une tension électrique représentative de l'amplitude de la vibration.

Au-delà de la conformation particulière d'un résonateur selon l'invention, une dernière voie d'amélioration vise la restitution de l'énergie perdue due au couplage acoustique entre le résonateur et son environnement.

L'invention vise donc aussi un dispositif comportant un résonateur mécanique selon l'invention et un moyen de confinement acoustique disposé à proximité du résonateur et réfléchissant l'énergie acoustique émise par le résonateur.

Ce moyen est une cavité acoustique résonante, caractérisée en ce que :

- elle possède une fréquence propre de résonance acoustique égale à la fréquence propre de résonance mécanique du diapason.
- le mode acoustique résonnant à la fréquence propre de résonance acoustique présente des nœuds et des ventres tels que chacun des deux chants intérieurs du résonateur se situe au niveau d'un ventre central et que chacun des deux chants extérieurs se situe au sein de ventres en opposition de phase avec le ventre central.
- pour maximiser le facteur de qualité acoustique, le matériau des parois de la cavité doit être rigide.

Un résonateur mécanique selon notre invention est donc très bien couplé à ce mode acoustique car ses dimensions sont compatibles avec la longueur d'onde acoustique, et donc avec la distribution spatiale du mode de pression.

La figure 1 illustre un résonateur de l'art antérieur de type diapason horloger.

La figure 2A illustre la variation de pression ∆P existant entre les deux chants d'une poutre de largeur Wb du résonateur de la figure 1.

La figure 2B illustre la variation de pression ∆P' existant entre les deux chants d'une poutre de largeur Wb' d'un résonateur selon l'invention.

La figure 3A illustre un diapason selon l'invention comportant deux poutres de largeur Wb'.

La figure 3B illustre une conformation optimisée d'électrodes de détection d'un diapason optimisé selon l'invention.

La figure 4A illustre le principe d'un diapason équipé de son moyen de confinement acoustique, avec une onde de pression stationnaire représentée en 1D.

Les figures 4B et 4C illustrent une des formes possibles pour le moyen de confinement acoustique, à savoir une cavité cylindrique vue de face et de dessus.

L'idée à la base de l'invention est de définir un objet simple présentant un couplage acoustique élevé dans les conditions de mise en œuvre des résonateurs : forme, nature du matériau constitutif de l'objet, mode vibratoire et nature du fluide.

L'objet choisi est une poutre parallélépipédique adaptée de longueur Lb', de largeur Wb' et d'épaisseur T', du type de celle constituant une branche de diapason de l'art antérieur. Elle est réalisée dans un matériau rigide, par exemple de type quartz ou silicium. La vibration de résonance de la poutre est une vibration de flexion dans le plan défini par ses longueur et largeur. Les modes de vibration sont le mode fondamental et, éventuellement, les modes harmoniques. Les fluides sont des gaz ou des mélanges de gaz comme l'oxygène, l'azote, le gaz carbonique, l'oxyde de carbone, l'hydrogène, l'hélium.

On appelle chants de la poutre les deux faces définies par la longueur Lb' et l'épaisseur T' de la poutre.

Les pertes d'énergie d'une poutre résonnante dans les conditions de mise en œuvre de l'invention sont de trois types : les pertes acoustiques, les pertes visqueuses et les pertes dans le support, ce dernier type de perte étant le seul essentiellement rencontré dans les résonateurs de type horloger encapsulés sous vide si l'on néglige les pertes thermoélastiques (Frédéric Lochon, Isabelle Dufour, Dominique Rebiere « A microcantilever chemical sensors optimization by taking into account losses ». Sensors and Actuators B : Chemical, Elsevier, 2006, 118, pp 292-296).

Pour exprimer l'influence des pertes d'un résonateur, le facteur de qualité est un moyen pratique. Le facteur de qualité d'un résonateur est défini comme étant le rapport entre l'énergie stockée dans le résonateur, sous forme d'énergie cinétique et potentielle de déformation, et l'énergie perdue au cours d'un cycle d'oscillation.

Le facteur de qualité global $Q_g$ du résonateur est défini par la formule :

$$1/Q_g = 1/Q_a + 1/Q_v + 1/Q_s$$

avec

$Q_a$ = facteur de qualité acoustique
$Q_v$ = facteur de qualité visqueux
$Q_s$ = facteur de qualité support

Cette formule souligne que c'est le facteur de qualité le plus faible qui dégrade le facteur de qualité global, la configuration optimale étant obtenue lorsque les facteurs de qualité sont égaux et le plus élevés possible.

Contrairement à cette approche, l'invention vise à définir les dimensions de la poutre afin d'augmenter le couplage acoustique de celle-ci avec le fluide environnant. En conséquence, les pertes acoustiques sont importantes ce qui va à l'encontre des enseignements de l'état de l'art.

La dimension caractérisante de l'invention est la largeur Wb' de la poutre. Dans l'état de l'art il n'existe pas de relation liant la largeur de la poutre à la longueur d'onde de l'onde émise à la fréquence de résonance f de la poutre.

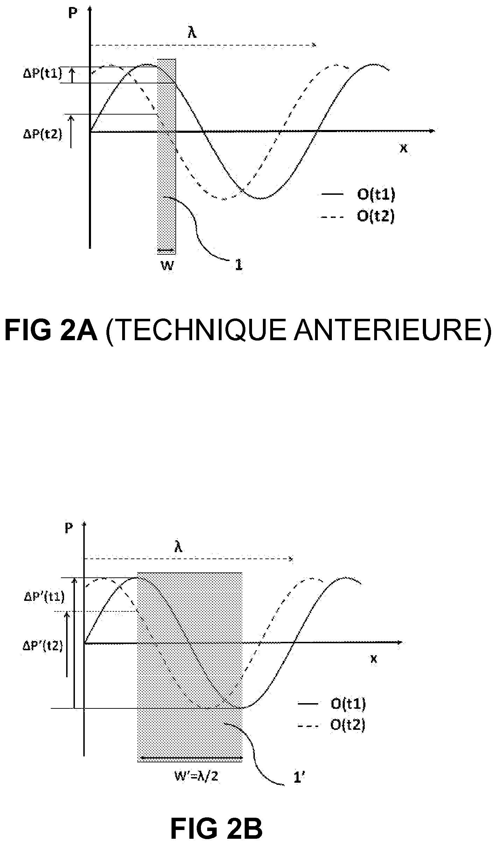

Sur les figures 2, la longueur d'onde est en abscisse et la pression en ordonnée. Sur ces figures, la largeur de la poutre Wb ou Wb', représentée en gris, est superposée à l'onde acoustique sinusoïdale à la fréquence de résonance f de la poutre. L'onde acoustique représentée est plane afin de faciliter la compréhension. Si l'onde vient d'une source extérieure, la source est très éloignée de la poutre et dans le plan de vibration de flexion de celle-ci. Si l'onde acoustique est générée par la poutre en mouvement, les déplacements de celle-ci sont négligés.

Dans le cas général illustré à la figure 2A, la variation de pression ΔP entre les chants de la poutre liée à sa largeur est faible. En revanche, dans le cas de l'invention, illustré à la figure 2B, la variation de pression ΔP' entre les chants de la poutre, séparés d'une distance égale à la moitié de la longueur d'onde, est maximale puisque les variations de pression sur chaque chant sont en opposition de phase.

Dans le cas d'une source extérieure, l'onde incidente crée un effort sur un chant d'amplitude égale et de signe opposé à l'effort appliqué sur l'autre chant, ce qui induit que les deux efforts s'additionnent de façon optimale pour exciter le mode de vibration en flexion de la poutre.

Généralement, l'onde acoustique n'est pas plane et il n'est pas possible d'obtenir des efforts en opposition de phase sur la surface des deux chants de la poutre. Dans ces conditions, la largeur Wb est comprise entre $\lambda/4 + n\lambda$ et $3\lambda/4 + n\lambda$, n étant un entier positif ou nul.

Ces dimensions s'appliquent aussi dans le cas où c'est la poutre qui génère l'onde acoustique. La dimension de largeur ainsi définie augmente le couplage acoustique de la poutre avec le fluide environnant.

Par ailleurs, les performances d'un résonateur selon l'invention ont été améliorées en limitant les pertes d'énergie des deux autres types : les pertes visqueuses et les pertes dans le support.

Pour limiter les pertes visqueuses d'un résonateur poutre optimisé de l'invention, la longueur Lb' de la poutre est un paramètre important car il détermine la fréquence de résonance. Le mode de flexion fondamental permet d'obtenir l'un des meilleurs facteurs de qualité.

Pour une poutre encastrée, l'élancement varie en fonction du matériau constitutif et du fluide environnant.

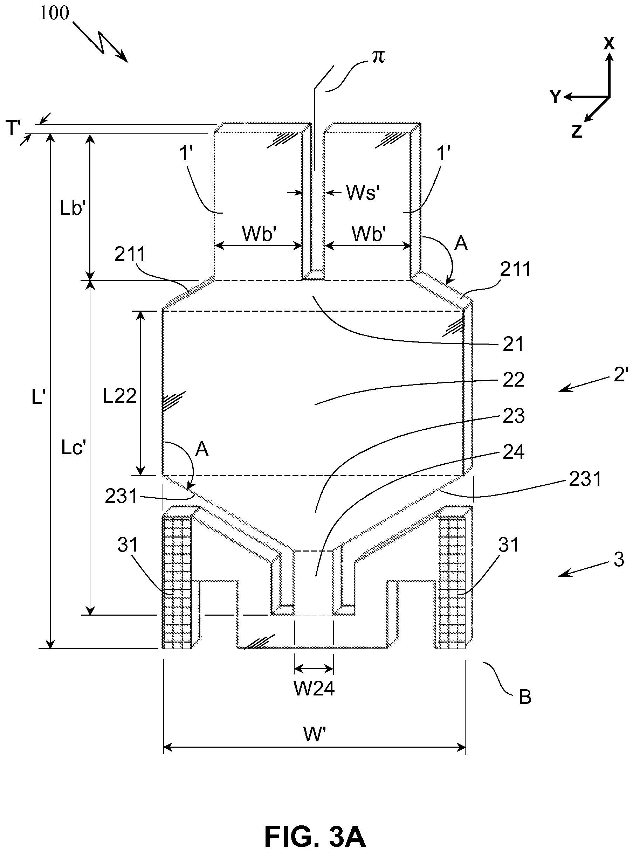

Les élancements optimisés pour une poutre encastrée à l'une de ses extrémités, comme représentés sur la figure 3A pour le quartz et le silicium dans l'air, l'hélium, l'hydrogène, l'oxygène et le gaz carbonique sont présentés dans le tableau ci-dessous :

|  | $CO_2$ | $O_2$ | Air | He | $H_2$ |
|---|---|---|---|---|---|
| Quartz | 2.6 | 2.4 | 2.3 | 1.4 | 1.2 |
| Silicium | 3.2 | 2.9 | 2.8 | 1.7 | 1.45 |

L'épaisseur T' de la poutre est de l'ordre du quart de la largeur Wb' de la poutre.

Pour une poutre encastrée à ses deux extrémités, l'élancement est compris entre 2 et 5 selon le matériau et la nature du fluide.

Pour limiter les pertes dans le support, il est connu que les performances d'une poutre unique sont moins bonnes que celles d'un diapason. Ce type de résonateur a donc été étudié pour être mis en œuvre dans le cadre de l'invention.

Le faible élancement des poutres conformes à l'invention modifie la nature des contraintes au niveau de la zone d'encastrement sur la partie commune fixée au support.

En particulier il existe des contraintes élevées de cisaillement dans la zone d'encastrement.

Il en résulte une conformation particulière du diapason de l'invention, illustrée à la figure 3A, qui augmente notablement la contribution de la partie commune à la vibration du résonateur et à la détection de ladite vibration.

Pour cet exemple de réalisation, la fréquence est égale à 42 500 Hz, soit une longueur d'onde de 8 mm dans l'air dans les conditions normales de pression, le matériau utilisé est du quartz sous forme d'une plaque plane usinée de dimensions L' = 23.75 mm, soit 2.97 $\lambda$, par W' = 13.8 mm, soit 1.72 $\lambda$ et d'épaisseur T' = 1 mm, soit $\lambda/8$.

Le plan de la plaque est sensiblement parallèle au plan cristallographique XY du quartz, et les axes longitudinaux des branches 1' sont sensiblement parallèles à l'axe cristallographique X du quartz (contrairement au diapason horloger montré à la figure 1A, dont les branches sont sensiblement parallèles à l'axe cristallographique Y du quartz). Le diapason 100 est symétrique par rapport à un plan π perpendiculaire au plan de la plaque.

Le diapason 100 est formé de deux branches sensiblement parallélépipédiques 1' de longueur Lb' = 6,8 mm, soit 0.85 $\lambda$, et de largeur Wb' = 4 mm, soit 0.5 $\lambda$, identiques et solidaires, chacune à une extrémité, d'une partie commune 2' constituée des quatre zones 21, 22, 23, 24 délimitées par des traits en pointillés.

La partie commune 2' est solidaire d'un bras de fixation 3 au niveau de la zone 24 opposée à la zone 21 solidaire des deux branches.

La zone de raccordement 21 entre les branches 1' et la partie principale 22 de la partie commune 2' présente une forme de trapèze isocèle dont les chants 211 tournés vers l'extérieur relient les chants extérieurs des branches aux chants de la partie commune principale 22 avec une inclinaison d'un angle A valant sensiblement 120° par rapport à l'axe X (ce qui permet, dans le cas où le diapason est réalisé par usinage chimique, d'éviter la formation de facettes obliques sur lesdits chants). La hauteur de ce trapèze est d'environ 1,4 mm.

De façon analogue la zone 23 permettant de raccorder les zones 22 et 24 de la partie commune 2' présente un angle de 120° par rapport à l'axe X cristallographique du quartz. La hauteur de ce trapèze vaut environ 3,5 mm.

Le diapason 100 est fixé, par exemple par collage, sur une embase de boîtier B (non représentée) au niveau des surfaces 31 (montrées par des hachures) du bras de fixation 3.

L'épaisseur T' de la plaque et la largeur de la fente Ws' sont sensiblement égales à 1 mm, soit $\lambda/8$. De façon générale, l'épaisseur T' et la distance W' sont voisines, c'est-à-dire que la distance Ws' peut être comprise entre 0,5 et 2 fois l'épaisseur T' de la plaque.

La partie commune 2' est solidaire des deux branches au niveau de la zone de raccordement 21 qui permet de raccorder les branches à la zone 22 de forme rectangulaire, et dont la dimension W' prise perpendiculairement au plan $\pi$ est supérieure à la largeur (2Wb' + Ws') contenant les deux branches : W' vaut sensiblement 1,5 fois (2Wb' + Ws'). Par ailleurs, la dimension L22 de la zone 22 prise parallèlement à l'axe X vaut sensiblement la moitié de la longueur Lc' de la partie commune 2'. Par exemple, Lc' vaut 15.45 mm, soit 1,93 $\lambda$ et L22 vaut 7,6 mm, soit 0,95 $\lambda$.

La largeur W24 de la zone 24 est très inférieure à W' : W24 vaut sensiblement 1,6 mm, soit $\lambda/5$.

Dans ces conditions, la surface de la partie commune 2' vaut environ trois fois la surface totale 2.Lb'.Wb' des deux branches 1'. Pour le diapason selon l'invention, la masse de matière de la partie commune est donc nettement plus important que celui des deux branches, contrairement au cas du diapason horloger.

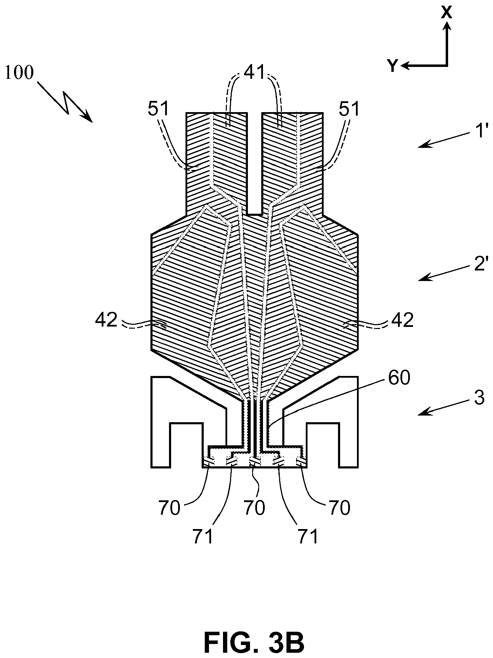

La figure 3B montre en vue de face des électrodes équipant le résonateur 100 de la figure 3A et permettant, par effet piézoélectrique, de détecter la vibration du résonateur. Les électrodes sont sous la forme de plages conductrices 41, 42 et 51, représentées par des zones hachurées, disposées sur les deux grandes faces de la plaque, et agissant dans les branches 1' et dans la partie commune 2'. Les électrodes 41 et 42 ont la même polarité électrique, différente de la polarité de l'électrode 51. Les électrodes 41, 42 et 51 disposées sur l'une des grandes faces sont directement en regard respectivement des électrodes 41, 42 et 51 disposées sur l'autre grande face (indiquées à l'aide d'un trait de référence en pointillé), et chacune des électrodes a la même polarité électrique que l'électrode disposée en regard sur l'autre grande face.

Les formes relativement complexes des électrodes 41, 42 et 51 sont issues de simulations numériques par éléments finis et sont liées à la distribution relativement complexe des contraintes mécaniques générées par la vibration du diapason, ces contraintes étant de trois types : la contrainte d'extension/compression $T_{XX}$ suivant l'axe X, la contrainte d'extension/compression $T_{YY}$ suivant l'axe Y, et la contrainte de cisaillement $T_{XY}$ dans le plan XY. La conformation des électrodes est caractéristique du fait qu'elles concernent indifféremment les poutres de façon classique, mais aussi la partie commune 2'. Les électrodes 41, 42 de même polarité, et les électrodes 51 sont raccordées à des plages de connexion respectivement 70 et 71 situées sur le bras de fixation 3, au moyen de pistes de raccordement de type référencé 60.

Ainsi, les plages de connexion 70 et 71 connectent respectivement les deux polarités de la totalité des électrodes, le diapason équipé de ses électrodes constituant un dipôle lié de façon piézoélectrique à la vibration.

Il est possible de détecter la vibration du diapason, par exemple en connectant les plages 70 et 71 à un amplificateur de charges différentiel (non représenté) qui permet de générer par exemple une tension électrique représentative de l'amplitude de la vibration. On notera que les électrodes montrées à la figure 3B, étant disposées seulement sur les deux grandes faces de la plaque, sont bien adaptées à des fabrications à faible coût. Par exemple, lorsque la structure du résonateur est obtenue par gravure chimique d'un wafer en quartz, les électrodes peuvent être aisément réalisées par gravure des masques métalliques recto et verso qui ont préalablement été utilisés pour la gravure chimique du quartz.

L'invention vise à concevoir un résonateur pour fonctionner dans un fluide. Or le résonateur décrit présente des pertes acoustiques importantes, ce qui n'est pas favorable en l'état à l'obtention d'un facteur de qualité global élevé.

Pour obtenir un dispositif optimisé conforme à l'invention et ayant un facteur de qualité élevé, il faut adjoindre au résonateur décrit ci-dessus un moyen apte à lui restituer la quasi-totalité de l'énergie des pertes acoustiques dues à son couplage avec le fluide.

Le rôle du moyen apte à restituer l'énergie acoustique ou moyen de confinement est de renvoyer les ondes acoustiques émises par le résonateur sur lui-même afin de créer une nouvelle force d'excitation participant alors à la vibration.

Le moyen de confinement de l'invention est une cavité acoustique résonnante. Le résonateur est placé au cœur de la cavité acoustique résonnante, qui prend la forme d'une cavité creuse. Il est connu que toute cavité creuse présente le phénomène de résonance acoustique. Il existe donc des modes propres acoustiques de résonance au sein de cette cavité, et chacun est associé à une fréquence de résonance et un facteur de qualité. Ces trois paramètres peuvent par exemple être calculés pour une forme quelconque par des logiciels de simulation par éléments finis.

La cavité acoustique selon l'invention, associée au résonateur mécanique en flexion, est caractérisé en ce que :

- elle possède une fréquence propre de résonance acoustique égale ou proche de la fréquence propre de résonance mécanique du diapason.
- le mode propre acoustique résonnant, correspondant à la fréquence propre de résonance acoustique du point précédent, présente des nœuds et des ventres suivant la position dans la cavité. Les ventres peuvent correspondre soit à des surpressions (+), soit à des dépressions (-). La majorité de la surface des deux chants intérieurs doit se situer au sein de ventres de même signe, c'est-à-dire soit une surpression, soit une dépression. La majorité de la surface des deux chants extérieurs doit également se retrouver au sein de ventres de même signe, mais de signe opposés à ceux des chants intérieurs.

- le facteur de qualité acoustique du mode précédemment décrit doit être maximisé. A titre d'exemple, le matériau utilisé pour réaliser les parois de la cavité doit être rigide.

Un résonateur mécanique selon notre invention est donc très bien couplé à ce mode acoustique dans la mesure où ses dimensions sont compatibles avec la longueur d'onde acoustique, et donc avec la distribution spatiale du mode de pression (dont la distance entre les ventres successifs est justement égal à $\lambda/2$).

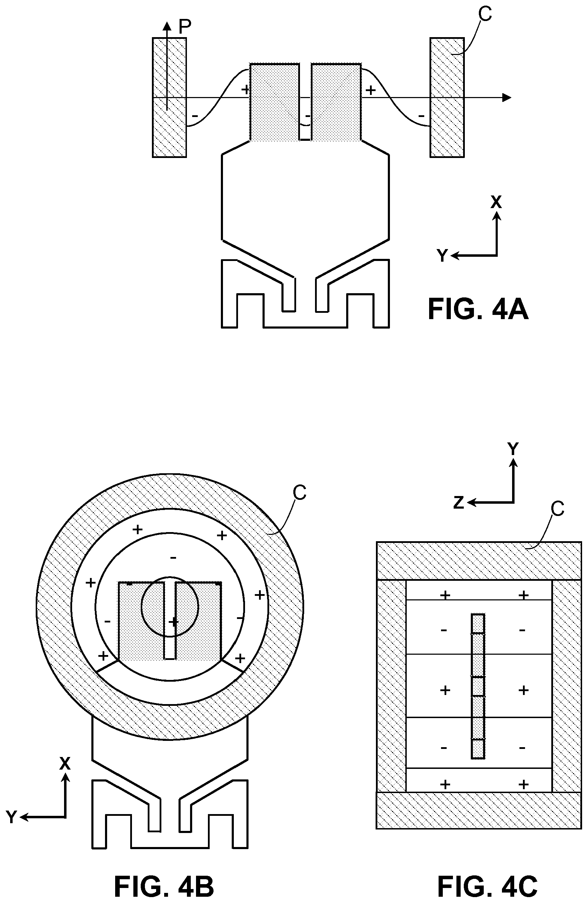

Une illustration simplifiée est présentée sur la figure 4A, où l'on a tracé les ventres de surpression (+) et les ventres de dépression (-) du mode acoustique résonnant. L'onde représentée possède bien cette propriété d'avoir une dépression pour les deux chants intérieurs au diapason, et une surpression pour les deux chants extérieurs.

Une autre illustration à la figure 4B montre le même principe pour une cavité de forme cylindrique de directrice circulaire de rayon $\lambda$, vue de face à la même échelle que celle du capteur. Le mode acoustique est alors radial et on voit bien que les chants occupent bien majoritairement les zones avec les signes voulus.

La figure 4C montre une vue de dessus de la même cavité.

Les facteurs de qualité typiques de résonateurs de type diapason dans un fluide respectivement de type horloger, du type selon l'invention seul et de type optimisé sont repris dans le tableau ci-dessous avec les facteurs de qualité globaux correspondant :

|          | $Q_s$   | $Q_v$   | $Q_a$     | $Q_g$  |
|----------|---------|---------|-----------|--------|
| Horloger | 80 000  | 10 000  | 2 000 000 | 8850   |
| Invention | 400 000 | 100 000 | 7 000     | 6437   |
| Optimisé | 400 000 | 100 000 | 400 000   | 66 667 |

Le facteur de qualité pénalisant des résonateurs horlogers, est celui de l'amortissement visqueux qui est lié à leurs petites dimensions, nécessaires à leurs applications. Le facteur de qualité est proportionnel au rapport surface/volume.

Le résonateur diapason de l'invention présente bien des facteurs de qualité support et visqueux améliorés par rapport au diapason horloger mais son facteur de qualité acoustique est fortement dégradé, comme souhaité.

Le facteur de qualité acoustique du dispositif optimisé comportant un résonateur de l'invention est très élevé du fait de la coopération du résonateur avec la cavité résonnante.

Le dispositif optimisé présente, comme il est souhaitable, des facteurs de qualité élevés et de valeurs voisines, c'est-à-dire dans une fourchette de 1 à 4 contre une fourchette de 1 à 200 pour un diapason horloger de l'état de l'art.

## Revendications

1. Résonateur mécanique (100), réalisé dans une plaque plane d'un matériau d'épaisseur T', comportant une partie commune (2') sur laquelle est encastrée au moins une poutre parallélépipédique (1') de longueur Lb', de largeur Wb', lesdites longueur Lb' et largeur Wb' étant mesurées parallèlement à la plaque, ladite poutre ayant un mode résonnant en flexion dans le plan de la plaque à une fréquence f à laquelle elle émet une onde acoustique de longueur d'onde $\lambda$ dans un fluide, poutre sur laquelle sont disposées des électrodes (41, 42, 51), **caractérisé en ce que**
la largeur Wb' est comprise entre $\lambda/4 + n\lambda$ et $3\lambda/4 + n\lambda$, n étant un entier positif ou nul.

2. Résonateur selon la revendication 1, **caractérisé en ce que** la largeur Wb' est égale à $\lambda/2 + n\lambda$.

3. Résonateur selon la revendication 1 ou 2, **caractérisé en ce que** la poutre est encastrée à ses deux extrémités et que le mode résonnant est le mode fondamental en flexion, un rapport de la longueur Lb' de la poutre sur la largeur Wb' de la poutre étant compris entre 2 et 5.

4. Résonateur selon la revendication 1 ou 2, **caractérisé en ce que** la poutre est encastrée à une seule de ses extrémités, et **en ce que** le mode résonnant est le mode fondamental en flexion, un rapport de la longueur Lb' de la poutre sur la largeur Wb' de la poutre étant compris entre 1,2 et 3,2.

5. Résonateur selon la revendication 4, **caractérisé en ce qu'**il comporte deux poutres (1') identiques, disposées parallèlement et formant diapason, encastrées sur la partie commune massive (2') dont une masse est comprise entre 2 et 4 fois celle des deux poutres.

6. Résonateur selon la revendication 5, **caractérisé en ce que** la partie commune (2') a une forme d'un parallélépipède rectangle (22) dont une longueur W' est supérieure au double de la largeur Wb' de chaque poutre (1') et une hauteur (L22) est supérieure à la longueur Lb' de chaque poutre, et de part et d'autre de ce parallélépipède sont disposés deux trapèzes isocèles (21, 23) dont des grandes bases ont une longueur égale à la longueur de la partie commune, les deux poutres (1'), disposées parallèlement à une distance Ws' comprise entre 0,5 et 2 fois l'épaisseur T' de la plaque, sont encastrées sur une petite base d'un premier des trapèzes isocèles (21), des faces d'épaisseur externes des poutres du diapason coïncidant avec des extrémités de cette petite base du premier trapèze isocèle, une petite base du second trapèze isocèle (23) supporte un élément de liaison intermédiaire (24) reliant le résonateur à un support, une longueur de ladite petite base du second trapèze isocèle étant inférieure à une moitié de la largeur Wb' d'une des poutres.

7. Résonateur selon la revendication 6, **caractérisé en ce que** les électrodes sont disposées sur des faces de chaque poutre (1') et de la partie commune (2') qui sont parallèles au plan de la plaque, dont elles occupent une surface totale hormis des zones d'isolation inter électrodes, lesdites zones d'isolation occupant moins de 20% de la surface totale desdites faces parallèles au plan de la plaque.

8. Résonateur selon la revendication 7, **caractérisé en ce que** les électrodes d'une même face parallèle au plan de la plaque comprennent : une électrode centrale (41) en forme de Y dont deux bras symétriques longent des faces d'épaisseur internes des deux poutres (1') qui sont en vis-à-vis, et dont une queue relie un point central de l'élément intermédiaire de liaison (24), deux électrodes externes (42) symétriques qui recouvrent chacune au moins 25% de la partie de face parallèle au plan de la plaque appartenant à la partie commune (2'), chacune dans une zone latérale opposée de ladite partie commune, et qui relient chacune un point externe respectif de l'élément intermédiaire de liaison, et deux électrodes intermédiaires (51) symétriques, chacune ayant un bras qui longe une face d'épaisseur externe de l'une des poutres, une partie de retour qui entoure une extrémité de l'une des électrodes externes opposée à l'élément intermédiaire de liaison, et une queue reliant un point intermédiaire respectif de l'élément intermédiaire de liaison, entre le point central et l'un des points externes.

9. Dispositif comportant un résonateur mécanique (100) selon l'une des revendications 1 à 8, **caractérisé en ce qu'**il comporte un moyen de confinement acoustique disposé à proximité du résonateur et réfléchissant l'énergie acoustique émise par le résonateur.

10. Dispositif selon la revendication 9 prise en dépendance d'une des revendications 5 à 8, **caractérisé en ce que** le moyen est une cavité acoustique résonnante à la fréquence de résonance mécanique du diapason, le mode acoustique résonnant de la cavité présentant des nœuds et des ventres tels que chacune des deux faces d'épaisseur intérieures des poutres du résonateur se situe au niveau d'un ventre central et que chacune des deux faces d'épaisseur extérieures des poutres se situe au niveau de ventres en opposition de phase avec le ventre central.

**Patentansprüche**

1. Mechanischer Resonator (100), hergestellt aus einer flachen Platte eines Materials der Dicke T', umfassend einen gemeinsamen Teil (2'), auf dem mindestens ein parallelepipedischer Balken (1') der Länge Lb' und der Breite Wb' eingelassen ist, wobei die Länge Lb' und die Breite Wb' parallel zur Platte gemessen sind, wobei der Balken in der Ebene der Platte einen Flexionsresonanzmodus bei einer Frequenz f aufweist, bei der er eine akustische Welle der Wellenlänge $\lambda$ in ein Fluid emittiert, wobei auf dem Balken Elektroden (41, 42, 51) angeordnet sind,
**dadurch gekennzeichnet,**
**dass** die Breite Wb' zwischen $\lambda/4 + n\lambda$ und $3\lambda/4 + n\lambda$ liegt, wobei n eine positive ganze Zahl oder Null ist.

2. Resonator nach Anspruch 1, **dadurch gekennzeichnet, dass** die Breite Wb' gleich $\lambda/2 + n\lambda$ ist.

3. Resonator nach Anspruch 1 oder 2, **dadurch gekennzeichnet, dass** der Balken an seinen beiden Enden eingelassen ist und dass der Resonanzmodus der Flexionsgrundmodus ist, wobei ein Verhältnis der Länge Lb' des Balkens zur Breite Wb' des Balkens zwischen 2 und 5 liegt.

4. Resonator nach Anspruch 1 oder 2, **dadurch gekennzeichnet, dass** der Balken nur an einem seiner Enden eingelassen ist und dass der Resonanzmodus der Flexionsgrundmodus ist, wobei ein Verhältnis der Länge Lb' des Balkens zur Breite Wb' des Balkenss zwischen 1,2 und 3,2 liegt.

5. Resonator nach Anspruch 4, **dadurch gekennzeichnet, dass** er zwei identische, parallel angeordnete und eine Stimmgabel bildende Balken (1') umfasst, die auf dem gemeinsamen massiven Teil (2') eingelassen sind, wobei die Masse zwischen dem 2- und 4-fachen der Masse der beiden Balken liegt.

6. Resonator nach Anspruch 5, **dadurch gekennzeichnet, dass** der gemeinsame Teil (2') die Form eines rechteckigen Parallelepipeds (22) hat, dessen Länge W' größer als die doppelte Breite Wb' jedes Balkens (1') und dessen Höhe (L22) größer als die Länge Lb' jedes Balkens ist, und zu beiden Seiten dieses Parallelepipeds zwei gleichschenklige Trapeze (21, 23) angeordnet sind, deren große Basen eine Länge haben, die gleich der Länge des gemeinsamen Teils ist, wobei die beiden Balken (1'), die in einem Abstand Ws',der zwischen 0,5 und 2 mal die Dicke T' der Platte beträgt, parallel angeordnet sind, auf einer kleinen Basis eines ersten der gleichschenkligen Trapeze (21) eingelassen sind, wobei äußere Dickenflächen der Stimmgabelbalken mit Enden dieser kleinen Basis des ersten gleichschenkligen Trapezes zusammenfallen, wobei eine kleine Basis des zweiten gleichschenkligen Trapezes (23) ein Zwischenverbindungselement (24) trägt, das den Resonator mit einem Träger verbindet, wobei eine Länge der kleinen Basis des zweiten gleichschenkligen Trapezes weniger als die Hälfte der Breite Wb' eines der Balken beträgt.

7. Resonator nach Anspruch 6, **dadurch gekennzeichnet, dass** die Elektroden auf Flächen jedes Balkens (1') und des gemeinsamen Teils (2') angeordnet sind, die parallel zur Ebene der Platte verlaufen, von der sie eine Gesamtfläche mit Ausnahme von Isolationsbereichen zwischen den Elektroden einnehmen, wobei die Isolationsbereiche weniger als 20% der Gesamtfläche der Flächen parallel zur Ebene der Platte einnehmen.

8. Resonator nach Anspruch 7, **dadurch gekennzeichnet, dass** die Elektroden einer gleichen zur Ebene der Platte parallelen Fläche umfassen: eine zentrale Elektrode (41) in Form eines Y, von der zwei symmetrische Arme entlang von inneren Dickenflächen der beiden einander gegenüberliegenden Balken (1') verlaufen und von der ein Schaft einen zentralen Punkt des Zwischenverbindungselements (24) verbindet, zwei symmetrische Außenelektroden (42), die jeweils mindestens 25 % des Teils der Fläche parallel zur Ebene der zum gemeinsamen Teil (2') gehörenden Platte bedecken, jeweils in einem gegenüberliegenden seitlichen Bereich des gemeinsamen Teils, und jeweils einen jeweiligen äußeren Punkt des Zwischenverbindungselements verbinden, und zwei symmetrische Zwischenelektroden (51), die jeweils einen Arm aufweisen, der entlang einer äußeren Dickenfläche eines der Balken verläuft, einen Rückführungsabschnitt, der ein Ende einer der äußeren Elektroden gegenüber dem Zwischenverbindungselement umgibt, und einen Schaft, der einen jeweiligen Zwischenpunkt des Zwischenverbindungselements zwischen dem zentralen Punkt und einem der äußeren Punkte verbindet.

9. Vorrichtung, umfassend einen mechanischen Resonator (100) nach einem der Ansprüche 1 bis 8, **dadurch gekennzeichnet, dass** sie ein akustisches Einschlussmittel umfasst, das in der Nähe des Resonators angeordnet ist und die vom Resonator emittierte akustische Energie reflektiert.

10. Vorrichtung nach Anspruch 9 in Abhängigkeit von einem der Ansprüche 5 bis 8, **dadurch gekennzeichnet, dass** das Mittel ein akustischer Hohlraum ist, der bei der mechanischen Resonanzfrequenz der Stimmgabel resonant ist, wobei der akustische Resonanzmodus des Hohlraums Knoten und Bäuche aufweist, so dass jede der beiden inneren Dickenflächen der Balken des Resonators auf der Höhe eines zentralen Bauchs angeordnet ist und so dass jede der beiden äußeren Dickenflächen der Balken auf der Höhe der Bäuche in Gegenphase zum zentralen Bauch angeordnet ist.

**Claims**

1. Mechanical resonator (100), produced in a flat plate of a material of thickness T', comprising a shared portion (2') on which is embedded at least one parallelepipedic prong (1') of length Lb', of width Wb' , said length Lb' and width Wb' being measured parallel to the plate, said prong having a resonance mode with bending in the plane of the plate at a frequency f at which it emits an acoustic wave of wavelength $\lambda$ in a fluid, electrodes (41, 42, 51) being arranged on said prong,
   **characterized in that**

the width Wb' is comprised between $\lambda/4 + n\lambda$ and $3\lambda/4 + n\lambda$, n being a positive integer or zero.

2. Resonator according to claim 1, **characterized in that** the width Wb' is equal to $\lambda/2 + n\lambda$.

3. Resonator according to claim 1 or 2, **characterized in that** the prong is embedded at both ends thereof and wherein the resonance mode is the fundamental bending mode, a ratio of the length Lb' of the prong to the width Wb' of the prong being comprised between 2 and 5.

4. Resonator according to claim 1 or 2, **characterized in that** the prong is embedded at only one of its ends, and the resonance mode is the fundamental bending mode, a ratio of the length Lb' of the prong to the width Wb' of the prong being comprised between 1.2 and 3.2.

5. Resonator according to claim 4, **characterized in that** it comprises two identical prongs (1') arranged in parallel and forming a tuning fork, embedded on the solid shared portion (2') having a mass comprised between 2 and 4 times that of the two prongs.

6. Resonator according to claim 5, **characterized in that** the shared portion (2') has a shape of a rectangular parallelepiped (22) having a length W' that is more than twice the width Wb' of each prong (1'), and a height (L22) that is greater than the length Lb' of each prong, and arranged one on either side of the parallelepiped are two isosceles trapezoids (21, 23) having large bases that have a length equal to the length of the shared portion, the two prongs (1') arranged in parallel at a distance Ws' comprised between 0.5 and 2 times the thickness T' of the plate, are embedded on a small base of a first of the isosceles trapezoids (21), outer edge faces of the tuning fork prongs being coincident with ends of this small base of the first isosceles trapezoid, a small base of the second isosceles trapezoid (23) supporting an intermediate connection member (24) connecting the resonator to a support, a length of said small base of the second isosceles trapezoid being less than half the width Wb' of one of the prongs.

7. Resonator according to claim 6, **characterized in that** the electrodes are arranged on faces of each prong (1') and of the shared portion (2') which are parallel to the plane of the plate, of which they occupy an entire surface except for inter-electrode insulation areas, said insulation areas occupying less than 20% of the entire surface area of said faces parallel to the plane of the plate.

8. Resonator according to claim 7, **characterized in that** the electrodes of one same face parallel to the plane of the plate comprise: a Y-shaped central electrode (41) having two symmetrical arms running alongside inner edge faces of the two prongs (1') which are facing one another, and having a tail connecting a central point of the intermediate connection member (24), two symmetrical external electrodes (42) which each cover at least 25% of the portion of the face parallel to the plane of the plate that belongs to the shared portion (2'), each in a lateral area opposite said shared portion, and which connect each a respective external point of the intermediate connection member, and two symmetrical intermediate electrodes (51), each having an arm running alongside an outer edge face of one of the prongs, a return portion which surrounds an end of one of the external electrodes opposite the intermediate connection member, and a tail connecting a respective intermediate point of the intermediate connection member, between the central point and one of the external points.

9. Device comprising a mechanical resonator (100) according to one of claims 1 to 8, **characterized in that** it comprises an acoustic confinement means arranged near the resonator and reflecting the acoustic energy emitted by the resonator.

10. Device according to claim 9 when dependent on one of claims 5 to 8, **characterized in that** the means is an acoustic cavity resonating at the mechanical resonance frequency of the tuning fork, the acoustic resonance mode of the cavity having nodes and antinodes such that each of the two inner edge faces of the prongs of the resonator is located at a central antinode and that each of the two outer edge faces of the prongs is located at antinodes that are in phase opposition to the central antinode.

**FIG. 1**
(TECHNIQUE
ANTERIEURE)

## FIG 2A (TECHNIQUE ANTERIEURE)

## FIG 2B

**FIG. 3A**

**FIG. 3B**

**FIG. 4A**

**FIG. 4B**

**FIG. 4C**

## RÉFÉRENCES CITÉES DANS LA DESCRIPTION

**Documents brevets cités dans la description**

- FR 2954489

**Littérature non-brevet citée dans la description**

- **A. A. KOSTEREV.** Quartz-enhanced photoacoustic spectroscopy. *OPTICS LETTERS,* 01 Novembre 2002, vol. 27 (21

- A microcantilever chemical sensors optimization by taking into account losses. **FRÉDÉRIC LOCHON ; ISABELLE DUFOUR ; DOMINIQUE REBIERE.** Sensors and Actuators B : Chemical. Elsevier, 2006, vol. 118, 292-296